# DEMANDE DE BREVET EUROPEEN

(11) **EP 4 102 578 A1**
(43) Date de publication de la demande: **14.12.2022**
(21) Numéro de dépôt: 22177283.3
(22) Date de dépôt: 03.06.2022
(51) Int. Cl.: H01L 31/05, H01L 31/0687, H01L 31/068, H01L 31/0392

(54) **ELÉMENT D'INTERCONNEXION ÉLECTRIQUE D'AU MOINS DEUX CELLULES PHOTOVOLTAÏQUES**

(30) Priorité: 07.06.2021 FR 2105947
(71) Demandeur: Commissariat à l'énergie atomique et aux énergies alternatives, 75015 Paris (FR)
(72) Inventeur: CARIOU, Romain, 38054 GRENOBLE CEDEX 09 (FR); GUERIN, Thomas, 38054 GRENOBLE CEDEX 09 (FR); PERON, Baptiste, 38054 GRENOBLE CEDEX 09 (FR); ROUJOL, Yannick, 38054 GRENOBLE CEDEX 09 (FR)
(74) Mandataire: Brevalex

(57) **Abrégé**

L'objet principal de l'invention est un élément d'interconnexion électrique (20) d'au moins deux cellules photovoltaïques (3) pour former un assemblage de cellules photovoltaïques (3) destiné à former un module photovoltaïque, l'élément d'interconnexion (20) comportant au moins un matériau conducteur électrique, caractérisé en ce que : l'élément d'interconnexion (20) se présente sous la forme d'un maillage comprenant une géométrie fractale formée par la répétition d'un motif unitaire (25) par translation pour obtenir une pluralité de motifs unitaires (25) de même taille et/ou par changement de taille du motif unitaire (25) pour obtenir une similarité du motif unitaire (25) à différentes échelles; l'élément d'interconnexion (20) présente un rapport entre le courant électrique conduit entre deux cellules photovoltaïques consécutives (3) et la section totale dudit au moins un matériau conducteur électrique entre deux cellules photovoltaïques consécutives (3) compris entre 0,1 et 20 A/mm².

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin, de matériaux III-V, de couches minces (CIGS, CdTE, perovskites, etc.) ou toute combinaison de ces différents matériaux. En particulier, l'invention est concernée par la problématique d'interconnexion de cellules photovoltaïques afin de former des assemblages, chaînes ou sous-ensembles de cellules photovoltaïques et ainsi des modules photovoltaïques.

L'invention concerne le domaine des modules photovoltaïques, utilisés pour des applications spatiales, mais aussi pour des applications terrestres, et également pour des applications de type mobilité électronique, ballons ou drones, entre autres. De manière plus générale, l'invention s'applique aux applications photovoltaïques pour lesquelles la problématique d'interconnexion de cellules photovoltaïques est pertinente.

L'invention propose ainsi un élément d'interconnexion électrique d'au moins deux cellules photovoltaïques, un assemblage d'au moins deux cellules photovoltaïques interconnectées par le biais d'un tel élément d'interconnexion, un module photovoltaïque et un procédé d'interconnexion électrique associés.

### ÉTAT DE LA TECHNIQUE ANTÉRIEURE

Un module photovoltaïque terrestre est classiquement constitué de cellules photovoltaïques électriquement connectées entre elles, généralement en série, et encapsulées dans un empilement de matériaux de type polymère et/ou verre. Cet empilement permet de protéger les cellules photovoltaïques de l'environnement extérieur, comme par exemple de la pluie, du vent, de la neige, de l'humidité, des rayonnements ultraviolets, des radiations, des chocs thermiques, entre autres, tout en conservant la fonction de conversion photoélectrique.

Ainsi, classiquement, un module photovoltaïque terrestre forme un empilement comportant successivement: un élément de protection arrière appelé « backsheet » en anglais, transparent ou non ; un premier film encapsulant polymère ; des cellules photovoltaïques reliées électriquement entre elles, typiquement par des interconnecteurs, le plus souvent des rubans de cuivre étamé ; un deuxième film encapsulant polymère ; un élément de protection avant appelé « frontsheet » en anglais, transparent, comme par exemple une plaque de verre ou un film polymère.

L'élément de protection avant est destiné à transmettre le rayonnement solaire aux cellules photovoltaïques pour générer de l'électricité, tout en les protégeant des contraintes de l'environnement. Cet empilement est ensuite solidarisé lors d'une étape de lamination à chaud, typiquement entre 100 et 150°C, pour faire fondre les films encapsulant et provoquer la réticulation des polymères, d'où il résulte la formation d'une enveloppe d'encapsulation solide des cellules photovoltaïques collée aux éléments de protection avant et arrière.

Pour les modules photovoltaïques terrestres, les interconnecteurs sont classiquement des rubans de cuivre avec un revêtement argent (Ag) ou étain (Sn). La connexion électrique entre rubans et cellules est assurée par soudure avec apport de matière, ce qui permet d'obtenir de bons contacts ohmiques à des températures inférieures à 400°C. Pour des températures plus basses, de l'ordre de 100°C, une autre approche peut consister à utiliser des colles conductrices, souvent constituées de particules métalliques dans une matrice polymère. Enfin, une dernière approche peut consister à effectuer une soudure sans apport de matière, ce qui peut alors nécessiter des températures localement élevées, par exemple supérieures à 960°C pour la fusion de l'argent, ou l'utilisation d'alliages à basse température de fusion pour maintenir un budget thermique réduit sur cette étape. L'article « A review of interconnection technologies for improved crystalline silicon solar cell photovoltaic module assembly », Musa T. Zarmai et al., School of Engineering, Faculty of Science and Engineering, University of Wolverhampton, Applied Energy 154, 173-182, 15 septembre 2015, présente les différentes approches connues d'interconnexion des cellules photovoltaïques dans le domaine du photovoltaïque terrestre.

Par ailleurs, un module photovoltaïque spatial classique est constitué d'assemblages de cellules photovoltaïques collés sur un substrat rigide de type nid d'abeilles. La structure et le type de cellules photovoltaïques utilisés diffèrent des modules photovoltaïques terrestres pour s'adapter aux contraintes environnementales et techniques drastiques du spatial (radiations, températures, vide, etc.). Ainsi, chaque cellule photovoltaïque est protégée par un verre individuel en face avant, solidarisé par le biais d'un adhésif transparent à la cellule, de sorte à former un ensemble appelé CIC pour « Coverglass Interconnect Cell » en anglais. Cet ensemble CIC est collé de manière permanente sur le substrat ou support mécanique par le biais d'un adhésif. Parmi les générations de panneaux solaires en cours de développement, certaines remplacent le CIC par un assemblage de cellules, donc un module, qui est lui-même collé sur un support mécanique.

Dans le domaine du photovoltaïque spatial, à la différence du photovoltaïque terrestre, les rubans d'interconnexion conducteurs ne courent pas sur toute la cellule, mais relient uniquement les espaces entre deux cellules consécutives avec des points de soudure en bordure de cellules. Ils s'étendent ainsi du bord de la cellule n-1 au bord de la cellule n. De plus, leur géométrie comprend des boucles de relaxation, par exemple hors du plan, pour encaisser les contraintes et déformations liées aux fortes amplitudes thermiques et aux différences de coefficients de dilatation thermique (ou CTE pour « Coefficient of Thermal Expansion » en anglais) des matériaux de l'empilement. Les dimensions des interconnecteurs pour le spatial sont souvent inférieures à la dizaine de millimètres pour les longueurs principales tandis que l'épaisseur reste en dessous du millimètre. Cette section est compatible avec les courants de fonctionnement des cellules multijonctions spatiales inférieurs à environ 1 A.

Afin d'éviter que ces interconnecteurs deviennent des résistances au sein du module, ils sont dimensionnés et possèdent des matériaux ayant une faible résistivité électrique. Les matériaux les plus courants sont le molybdène (Mo), un alliage ferreux de nickel cobalt (FeNiCo), typiquement le Kovar^{®}, ou un alliage de fer nickel, typiquement l'Invar^{®}. Ensuite va venir s'ajouter au-dessus et en dessous de cette base, le plaquage. L'objectif du plaquage est de faire la continuité électrique entre les deux cellules. Pour cela, les métaux ayant la résistivité électrique la plus faible vont être choisis. Les demandes de brevet EP 1 128 445 A2, WO 2012/081382 A2 et EP 3 550 615 A1 présentent différentes approches connues d'interconnexion des cellules photovoltaïques dans le domaine du photovoltaïque spatial. On distingue notamment une géométrie d'interconnecteurs avec boucles de relaxation hors du plan, et une géométrie d'interconnecteurs avec boucles de relaxation dans le plan.

L'interconnecteur est un élément critique du fait de sa fonction essentielle de transport de courant. Il doit résister aux dilatations liées aux contraintes environnementales lors de la fabrication, par exemple lors d'une soudure, ou lors du fonctionnement du module photovoltaïque, par exemple lors d'éclipses au cours d'orbites terrestres, et ce malgré les différences de coefficients de dilatation thermique (CTE) de l'empilement.

Aussi, pour minimiser les risques de casse et de perte de continuité électrique, les stratégies suivantes peuvent être employées : diminution de la température de soudure (par exemple par le biais d'un alliage à basse température de fusion) et/ou de lamination, et refroidissement ralenti et contrôlé lors de la fabrication ; utilisation de matériaux à faible rigidité pour encaisser les déformation et choix de coefficients de dilatation thermique (CTE) proches; design ou géométrie d'éléments d'interconnexion pouvant accommoder d'importantes déformations sans rupture. Cette dernière stratégie est celle qui est principalement explorée par la présente invention.

On connait déjà de la demande de brevet EP 1 128 445 A2 un principe d'interconnecteur avec trois parties dont une partie est constituée de motifs répétés pour remplacer la boucle de relaxation. Une subdivision en petites sections est obtenue qui ne conduit pas à former des sous-ensembles dont la géométrie ressemble à celle de la structure globale. Aussi, les motifs répétés ne suivent pas un critère d'auto-similarité. La problématique de l'ombrage n'est pas adressée ici car les interconnexions ne recouvrent pas les faces avant des cellules photovoltaïques.

Par ailleurs, on connaît dans le domaine de l'électronique flexible, notamment pour l'optoélectronique, le biomédical ou la robotique, des topologies de conducteurs électriques permettant d'importantes déformations, inspirées de structures fractales.

Il existe ainsi un besoin pour concevoir un nouveau principe d'interconnexion des cellules photovoltaïques permettant notamment de répondre à une triple problématique : celle de l'ombrage, celle de la dilatation et celle de la conductivité électrique.

Ainsi, les interconnecteurs doivent pouvoir limiter l'ombrage qu'ils créent lorsqu'ils recouvrent une partie de la surface de la face avant d'une cellule. De plus, les interconnecteurs doivent résister aux contraintes et déformations mécaniques ou thermomécaniques importantes auxquelles ils sont soumis, notamment en fonction de la configuration de l'assemblage des cellules photovoltaïques (par exemple pliage / dépliage / enroulage d'une voile solaire dans le cas de panneaux pliables / enroulables / flexibles) et de l'environnement dans lequel les cellules sont exposées lors de la fabrication et/ou pendant leur fonctionnement (par exemple des variations thermiques dues à des éclipses, cyclages thermiques, etc.). Enfin, les interconnecteurs doivent pouvoir assurer la connexion électrique entre les cellules tout en minimisant les pertes ohmiques.

### EXPOSÉ DE L'INVENTION

L'invention a pour but de remédier au moins partiellement aux besoins mentionnés ci-dessus et aux inconvénients relatifs aux réalisations de l'art antérieur.

En particulier, l'invention vise à permettre l'interconnexion de cellules photovoltaïques en maintenant une excellente conductivité ohmique entre les cellules quelques soient les déformations appliquées, mécaniques ou thermomécaniques.

L'invention a ainsi pour objet, selon l'un de ses aspects, un élément d'interconnexion électrique d'au moins deux cellules photovoltaïques pour former un assemblage de cellules photovoltaïques destiné à former un module photovoltaïque, l'élément d'interconnexion comportant au moins un matériau conducteur électrique, caractérisé en ce que :
- l'élément d'interconnexion se présente sous la forme d'un maillage comprenant une géométrie fractale formée par la répétition d'un motif unitaire par translation pour obtenir une pluralité de motifs unitaires de même taille et/ou par changement de taille du motif unitaire pour obtenir une similarité du motif unitaire à différentes échelles,
- l'élément d'interconnexion présente un rapport entre le courant électrique conduit entre deux cellules photovoltaïques consécutives et la section totale dudit au moins un matériau conducteur électrique entre deux cellules photovoltaïques consécutives compris entre 0,1 et 20A/mm².

Par « géométrie fractale », on entend que l'élément d'interconnexion présente une géométrie exactement ou statistiquement autosimilaire, c'est-à-dire qu'on retrouve des similarités en l'observant à différentes échelles. L'élément d'interconnexion présente ainsi des détails similaires à des échelles arbitrairement petites ou grandes.

Grâce à la géométrie fractale, d'importantes déformations sont possibles sans atteindre de déformations plastiques ni de ruptures. De plus, ce type de géométrie présente l'avantage d'offrir une redondance de chemins de conduction électrique pour le passage d'une cellule photovoltaïque à une autre cellule photovoltaïque consécutive, ce qui offre une robustesse vis-à-vis du fonctionnement du module photovoltaïque.

L'élément d'interconnexion selon l'invention peut en outre comporter l'une ou plusieurs des caractéristiques suivantes prises isolément ou suivant toutes combinaisons techniques possibles.

Préférentiellement, l'élément d'interconnexion peut comporter un ou plusieurs métaux et/ou alliages métalliques conducteurs.

L'élément d'interconnexion peut présenter un rapport entre le courant électrique conduit entre deux cellules photovoltaïques consécutives et la section totale dudit au moins un matériau conducteur électrique entre deux cellules photovoltaïques consécutives compris entre 0,5 et 15 A/mm².

Avantageusement, l'élément d'interconnexion peut présenter une géométrie planaire. Autrement dit, l'élément d'interconnexion présente avantageusement une géométrie bidimensionnelle dans un plan. Il est apte à se déformer dans le plan. De cette façon, il peut présenter une bonne compatibilité avec les procédés d'encapsulation et de lamination. En particulier, il est possible de réaliser l'empilement des différentes couches, dont celle comprenant les cellules photovoltaïques interconnectées selon le principe de l'invention, destinées à former un module photovoltaïque sans subir de contraintes liées à l'usage de la troisième dimension pour l'élément d'interconnexion. Autrement dit encore, l'élément d'interconnexion ne s'étend avantageusement pas hors du plan contrairement à la plupart boucles de relaxation des réalisations de l'art antérieur.

Par ailleurs, la taille de maille de l'élément d'interconnexion, définie comme la longueur du côté du plus petit carré fictif dans lequel est inscrit le motif unitaire, peut être comprise entre 1 et 80 mm, notamment entre 10 et 50 mm.

De plus, la géométrie fractale par changement de taille du motif unitaire peut être faite à un ordre supérieur ou égal à 1, à savoir qu'elle peut comporter une similarité du motif unitaire à au moins deux échelles différentes.

L'élément d'interconnexion peut présenter une capacité de déformation supérieure ou égale à 20 %, notamment supérieure ou égale à 40 %.

En outre, l'élément d'interconnexion peut se présenter sous la forme d'un maillage de type triangulaire, de type pavage trihexagonal, encore appelé kagomé, ou de type nid d'abeilles, entre autres.

Par ailleurs, l'invention a encore pour objet, selon un autre de ses aspects, un assemblage d'au moins deux cellules photovoltaïques, caractérisé en ce que lesdites au moins deux cellules photovoltaïques sont interconnectées électriquement entre elles par le biais d'au moins un élément d'interconnexion tel que défini précédemment.

Chaque cellule photovoltaïque peut comporter une surface sur laquelle ledit au moins un élément d'interconnexion est disposé au moins en partie, notamment en totalité ou en partie.

L'ombrage dudit au moins un élément d'interconnexion sur une surface d'une cellule photovoltaïque destinée à recevoir un flux lumineux, à savoir le recouvrement de cette surface par ledit au moins un élément d'interconnexion empêchant le passage du flux lumineux, peut être compris entre 0,2 % et 5 % de la surface de la cellule photovoltaïque, notamment compris entre 0,2 % et 3 % de la surface de la cellule photovoltaïque.

Il est à noter que la méthode de calcul de l'ombrage peut différer selon la nature dudit au moins un élément d'interconnexion. Ainsi, dans le cas d'un ruban, l'ombrage est défini comme la section du ruban projetée sur la cellule photovoltaïque. Dans le cas d'un fil cylindrique, l'ombrage est défini par convention comme la section projetée sur la cellule photovoltaïque à laquelle on enlève 25 % de celle-ci.

La fraction de la surface d'une cellule photovoltaïque recouverte par ledit au moins un élément d'interconnexion peut être comprise entre 10 et 100 %, notamment entre 50 et 100 %, notamment encore entre 80 et 100 %.

Par ailleurs, dans la zone inter-cellules correspondant à la partie dudit au moins un élément d'interconnexion située entre deux cellules photovoltaïques consécutives, sans recouvrement d'une surface de cellule photovoltaïque, le nombre de noeuds, correspondant au lieu de réunion d'au moins deux motifs unitaires, peut être compris entre 2 et 50, notamment entre 5 et 15.

L'élément d'interconnexion peut se présenter sous la forme d'une bande, recouvrant partiellement ou totalement la surface d'une cellule photovoltaïque. En particulier, une pluralité d'éléments d'interconnexion sous formes de bandes, préférentiellement parallèles entre elles, peut recouvrir partiellement la surface d'une cellule photovoltaïque.

En outre, l'invention a encore pour objet, selon un autre de ses aspects, un module photovoltaïque, caractérisé en ce qu'il comporte une pluralité de cellules photovoltaïques interconnectées électriquement entre elles par le biais d'au moins un élément d'interconnexion tel que défini précédemment ou en ce qu'il comporte un assemblage tel que défini précédemment.

Le module photovoltaïque peut avantageusement comporter une première couche transparente formant une face avant du module photovoltaïque, une deuxième couche formant une face arrière du module photovoltaïque, et la pluralité de cellules photovoltaïques reliées électriquement entre elles par le biais dudit au moins un élément d'interconnexion et disposées côte à côte entre la première couche et la deuxième couche. La face arrière du module peut être collée par une couche d'adhésion sur un support, typiquement sous forme de voile solaire.

Le support peut être rigide ou souple. Par exemple, le support peut être rigide et prévu pour des applications spatiales. En particulier, le support peut comporter une structure en nid d'abeilles, par exemple en aluminium. En variante, le support peut être souple, étant par exemple réalisé en polyimide, par exemple un film Kapton^{®}, en polyétheréthercétone (PEEK) ou encore en matériau thermoplastique filé à partir d'un aramide, par exemple un film Vectran^{®}, entre autres.

En outre, le support peut être de faible épaisseur. Par exemple, l'épaisseur du support peut être comprise entre 10 µm et 5 mm, préférentiellement entre 25 et 125 µm.

Par ailleurs, l'invention a aussi pour objet, selon un autre de ses aspects, un procédé d'interconnexion électrique d'au moins deux cellules photovoltaïques, caractérisé en ce qu'il comporte l'étape consistant à interconnecter au moins deux cellules photovoltaïques au moyen d'au moins un élément d'interconnexion tel que défini précédemment.

Le procédé d'interconnexion peut comporter l'étape de positionnement dudit au moins un élément d'interconnexion comportant ledit au moins un matériau conducteur électrique sur un film support en un matériau polymère. En particulier, ledit au moins un matériau conducteur électrique peut être formé à partir d'un fil cylindrique, présentant la géométrie fractale, lequel est positionné sur un film support polymère.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
La figure 1 représente, selon une vue éclatée en perspective, un exemple de module, ou assemblage, photovoltaïque spatial rigide,
La figure 2 illustre schématiquement la création d'une géométrie fractale d'ordre 2 avec l'exemple du triangle de Sierpinski, pour former un élément d'interconnexion conforme à l'invention,
La figure 3 et la figure 4 illustrent, partiellement selon une vue de face, deux exemples d'éléments d'interconnexion conformes à l'invention avec des motifs différents,
La figure 5 représente, selon une vue de face, un exemple d'élément d'interconnexion conforme à l'invention, sous forme de nappe d'interconnexion, reliant deux cellules photovoltaïques,
La figure 6 représente, selon une vue de face, un autre exemple d'élément d'interconnexion conforme à l'invention, sous forme de nappe d'interconnexion, reliant deux cellules photovoltaïques, avec une taille de maille plus réduite par rapport à la taille de maille de l'exemple de la figure 5,
La figure 7 et la figure 8 illustrent, selon une vue de face, deux exemples d'application, respectivement totale et partielle, d'un élément d'interconnexion conforme à l'invention sur deux cellules photovoltaïques, et
La figure 9 et la figure 10 illustrent, selon une vue de face, deux autres exemples d'application, respectivement totale et partielle, d'éléments d'interconnexion en bandes conformes à l'invention sur deux cellules photovoltaïques.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Dans la description des exemples de mise en œuvre de l'invention qui vont suivre, le domaine d'application concerné est préférentiellement celui des modules photovoltaïques pour des applications spatiales. Toutefois, l'invention s'applique aussi aux modules photovoltaïques prévus pour des applications terrestres.

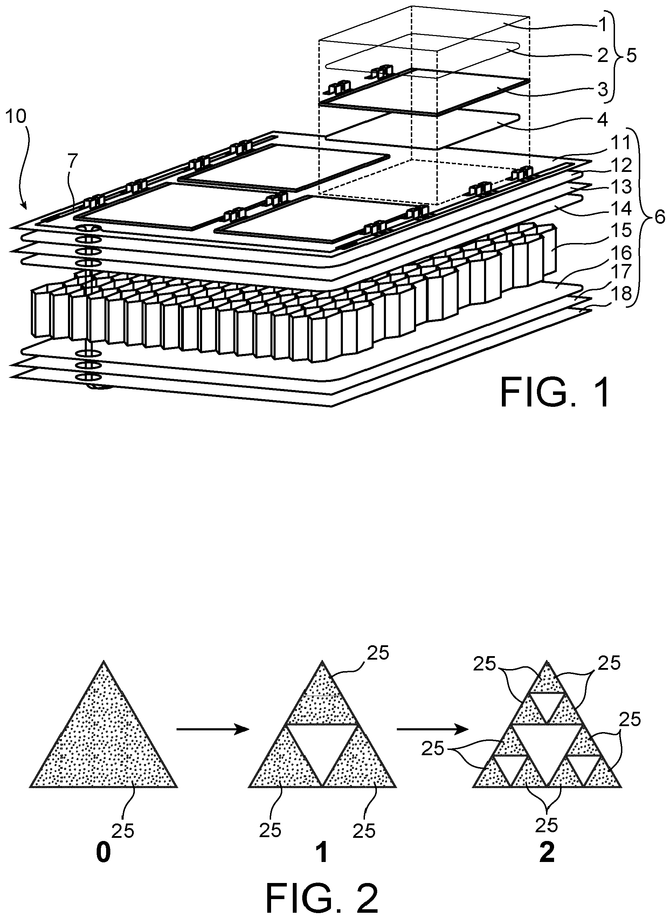

La figure 1 illustre tout d'abord, selon une vue éclatée en perspective, un exemple de module, ou assemblage, photovoltaïque 10 spatial rigide.

Dans cet exemple, l'assemblage photovoltaïque 10 comporte un support rigide 6 sur lequel est collée une pluralité de modules photovoltaïques 5 de type CIC pour « Coverglass Interconnect Cell » en anglais.

Le support rigide 6 comporte successivement (de haut en bas) : une couche isolante 11 sur laquelle sont collés les modules photovoltaïques 5 ; une couche d'adhésif 12 ; une couche polymère 13 ; une couche d'adhésif 14 ; une structure en nid d'abeilles 15 ; une couche d'adhésif 16 ; une couche polymère 17 ; et une couche de contrôle thermique 18.

Par ailleurs, chaque module photovoltaïque 5 de type CIC comporte : une face avant 1 en verre; une couche d'adhésif transparent 2; et une ou plusieurs cellules photovoltaïques 3.

Une couche d'adhésion 4 est utilisée entre chaque module photovoltaïque 5 et le support rigide 6 pour permettre la fixation des modules photovoltaïques 5 sur le support rigide 6 et notamment par le biais d'une adhésion sur la couche 11, et ainsi la fabrication de l'assemblage photovoltaïque 10.

En outre, les modules photovoltaïques 5, une fois collés, sont connectés électriquement à des moyens de connexion électrique 7, notamment des harnais électriques, présents sur le support rigide 6.

Les cellules photovoltaïques 3 d'un module photovoltaïque 5 sont interconnectées électriquement entre elles. On va ainsi maintenant décrire, en référence aux figures 2 à 10, le principe d'interconnexion des cellules photovoltaïques 3 utilisant un ou plusieurs éléments d'interconnexion électrique 20 conformes à l'invention.

Un élément d'interconnexion 20 conforme à l'invention se présente sous la forme d'un maillage comprenant une géométrie fractale. Avantageusement, une géométrie fractale de l'élément d'interconnexion 20 lui confère une capacité à encaisser des déformations sans rupture par la déformation mécanique liée à cette géométrie particulière, cette capacité ne reposant plus uniquement sur les propriétés thermomécaniques du matériau conducteur. De plus, le critère d'auto-similarité de ce type de motif fractal offre une redondance importante de chemins de courant électrique, ce qui augmente considérablement la fiabilité de l'interconnexion.

La géométrie fractale peut être formée par la répétition d'un motif unitaire 25 par changement de taille de celui-ci pour obtenir une similarité du motif unitaire 25 à différentes échelles. Ce changement de taille du motif unitaire 25 peut être fait à un ordre supérieur ou égal à 1, à savoir qu'une similarité du motif unitaire 25 est obtenue à au moins deux échelles différentes.

A titre d'exemple, la figure 2 illustre schématiquement la création d'une géométrie fractale d'ordre 2, apte à être employée dans un élément d'interconnexion 20 conforme à l'invention, avec l'exemple du triangle de Sierpinski. A l'ordre 0 (à gauche), le motif unitaire 25, ici un triangle, n'est pas répété. Il constitue la forme de départ. A l'ordre 1 (au milieu), le motif unitaire 25 change d'échelle avec une triple répétition. Puis, à l'ordre 2 (à droite), l'échelle est de nouveau modifiée pour répéter neuf fois le motif unitaire 25 qui devient de plus en plus petit.

La géométrie fractale peut également être formée par la répétition d'un motif unitaire 25 par translation pour obtenir une pluralité de motifs unitaires 25 de même taille.

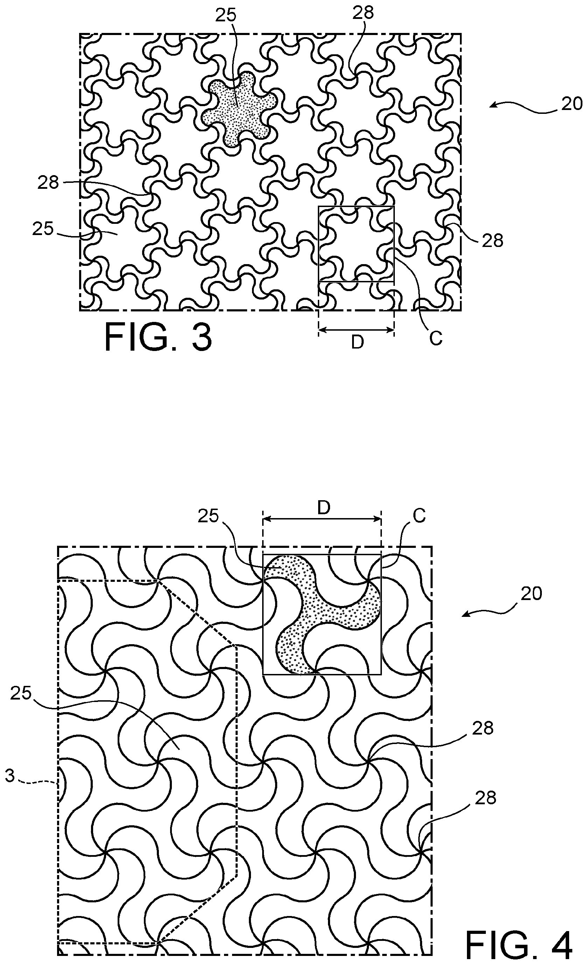

A titre d'exemple, les figures 3 et 4 représentent deux exemples d'éléments d'interconnexion 20 avec des maillages différents.

La figure 3 représente un élément d'interconnexion 20 sous forme de nappe formée par la répétition par translation d'un motif unitaire 25, identifié en noir sur la figure 3 et dont la forme est obtenue à partir de l'ondulation en concavité des côtés d'un hexagone. Les motifs unitaires 25 sont reliés les uns aux autres par le biais de nœuds 28. Le maillage ainsi défini est du type pavage trihexagonal, ou encore dénommé kagomé d'après l'appellation japonaise.

La figure 4 représente un élément d'interconnexion 20 sous forme de nappe formée par la répétition par translation d'un motif unitaire 25, identifié en noir sur la figure 4 et dont la forme est obtenue à partir de l'ondulation en concavité des côtés d'un triangle. Ici aussi, les motifs unitaires 25 sont reliés les uns aux autres par le biais de nœuds 28. De plus, sur cette figure 4 est également représentée le contour d'une cellule photovoltaïque 3, par exemple de type III-V 4×8 cm. Le maillage ainsi défini est du type triangulaire.

Bien entendu, d'autres formes peuvent être envisagées pour le motif unitaire 25, comme par exemple de type double fer à cheval avec un angle d'arc compris entre 120 et 210°, et d'autres types de maillage également, comme par exemple du type nid d'abeilles. Dans tous les cas, les motifs unitaires 25 sont avantageusement tous reliés entre eux pour permettre la redondance de chemins de courant électrique. De plus, la géométrie fractale confère à l'élément d'interconnexion 20 des propriétés de flexibilité et de dilatation avantageuses.

Afin de pouvoir assurer un transport de courant électrique efficace, l'élément d'interconnexion 20 présente un rapport optimisé entre le courant électrique conduit entre deux cellules photovoltaïques consécutives 3 et la section totale du matériau conducteur électrique, sous forme de métal ou alliage métallique conducteur, entre deux cellules photovoltaïques consécutives 3, dans lequel l'élément d'interconnexion 20 est formé, qui est compris entre 0,1 et 20 A/mm², et préférentiellement entre 0,5 et 15 A/mm². Ce rapport est indépendant du type de cellules interconnectées et du spectre solaire auquel elles sont exposées.

De plus, comme représenté sur les figures 3 et 4, l'élément d'interconnexion 20 présente avantageusement une géométrie planaire, étant apte à se déformer dans le plan. Précisément, sa limite d'élasticité (0,3 % de déformation plastique résiduelle) permet des déformations linéaires supérieures ou égales à 20 % par rapport à la dimension initiale, et préférentiellement supérieures ou égales à 40 %, dans les deux dimensions du plan. Ces déformations sont également désignées par l'expression « capacité de déformation ».

En outre, comme visible sur les figures 3 et 4, l'élément d'interconnexion 20 est défini par une taille de maille. Précisément, la taille de maille D de l'élément d'interconnexion 20 est définie comme la longueur du côté D du plus petit carré fictif dans lequel est inscrit le motif unitaire 25. Elle est comprise entre 1 et 80 mm, et préférentiellement entre 10 et 50 mm.

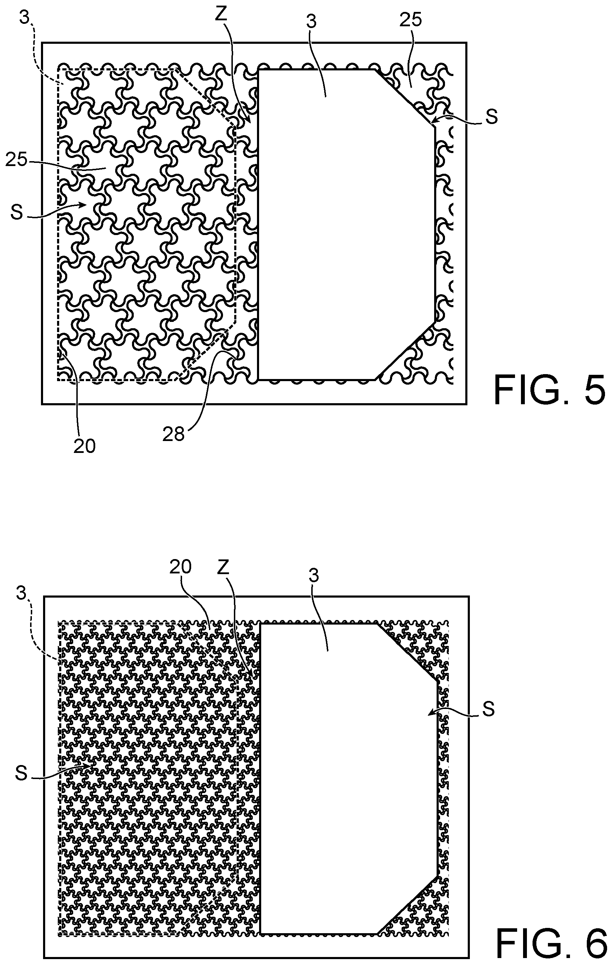

La figure 5 représente un exemple d'assemblage de deux cellules photovoltaïques 3, ici de type III-V 4 × 8 cm, qui sont interconnectées par le biais d'un élément d'interconnexion 20 sous forme de nappe, pouvant comporter ou non un matériau polymère support, utilisant la géométrie de l'exemple de la figure 3. Par ailleurs, la figure 6 représente un exemple analogue à celui de la figure 5 avec toutefois une taille de maille réduite.

L'élément d'interconnexion 20 est ici disposé sur la face avant de la première cellule 3, puis sur la face arrière de la deuxième cellule 3 mais cet agencement dépend du type de cellule photovoltaïque 3 utilisée. Dans un mode particulier de l'invention, l'élément d'interconnexion 20 peut être en contact électrique avec la métallisation de la face avant de la première cellule 3, puis avec la métallisation de la face arrière de la deuxième cellule 3. Cette métallisation peut par exemple se présenter sous la forme de doigts de métallisation ou doigts de collecte, avec éventuellement des busbars (ou barres d'interconnexion). De façon générale, l'interconnexion peut ainsi être réalisée d'une cellule à une autre avec un recouvrement des faces des cellules, et non par une interconnexion de bord à bord des cellules.

Ainsi, chaque cellule photovoltaïque 3 comporte une surface S sur laquelle l'élément d'interconnexion 20 est disposé, ici en totalité. Or, la conduction électrique et l'ombrage variant à l'opposé, une plage de valeurs optimales existe également pour l'ombrage. Ainsi, l'ombrage de l'élément d'interconnexion 20 sur une surface S d'une cellule photovoltaïque 3 destinée à recevoir un flux lumineux, à savoir le recouvrement de cette surface S empêchant le passage du flux lumineux, est compris entre 0,2 % et 5 % de la surface S, et préférentiellement compris entre 0,2 % et 3 %.

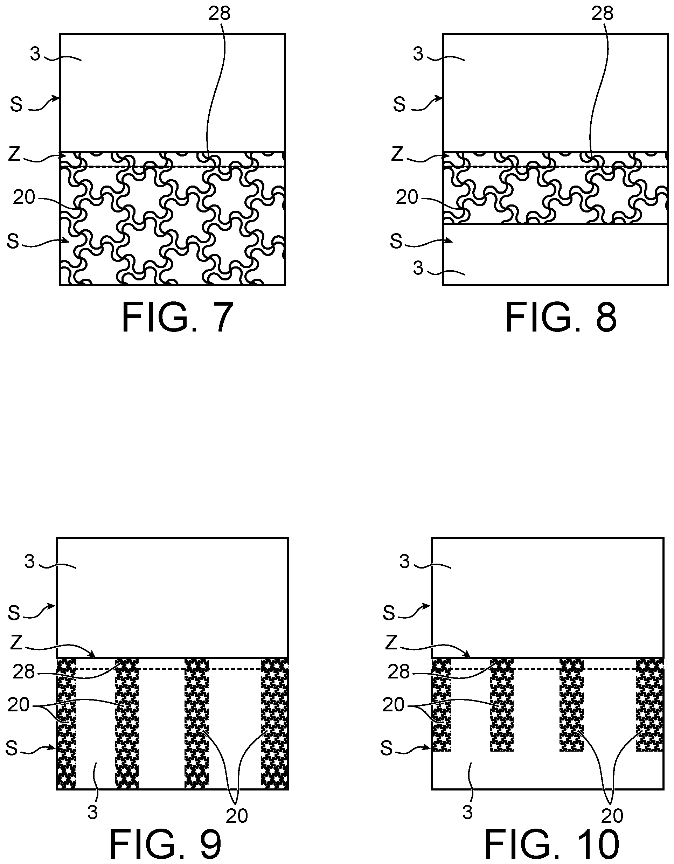

Le recouvrement total, cas des figures 5, 6 et 7, ou partiel, cas des figures 8, 9 et 10, de la surface S d'une cellule photovoltaïque 3 doit être choisi en fonction d'une double contrainte d'ombrage et de pertes résistives minimisées. Le recouvrement total a l'avantage d'être simple de fabrication et d'être uniforme d'un point de vue électrique mais il entraîne une contrainte importante sur l'ombrage. Le recouvrement partiel a l'avantage de diminuer l'ombrage mais il entraîne une contrainte électrique et nécessite ainsi de recouvrir davantage que le bord de chaque cellule.

Aussi, la fraction de la surface S de chaque cellule photovoltaïque 3 recouverte par l'élément d'interconnexion 20 est comprise entre 10 et 100 %, notamment entre 50 et 100 %, et notamment encore entre 80 et 100 %.

Par ailleurs, comme visible sur les figures 5 à 10, il existe une zone inter-cellules Z correspondant à la partie du ou des éléments d'interconnexion 20 située entre deux cellules photovoltaïques 3 consécutives, sans recouvrement d'une surface S de cellule photovoltaïque 3. Dans cette partie, le nombre de nœuds 28, correspondant au lieu de réunion d'au moins deux motifs unitaires 25, est compris entre 2 et 50, et préférentiellement entre 5 et 15.

Le Tableau 1 ci-dessous présente des valeurs de certains paramètres présentés précédemment avec deux types de maillage de l'élément d'interconnexion 20 (triangulaire et kagomé), utilisant un fil cylindrique en métal ou alliage métallique, en particulier un fil de cuivre recouvert par un revêtement à bas point de fusion de type SnBiAg (alliages à base d'étain-bismuth-argent), dont le diamètre est communiqué (en variante, il pourrait aussi s'agir d'un ruban), et deux types de cellules photovoltaïques 3 (cellules de type III-V triple jonction 4 × 8 cm² à 0,52 A et de type Si, de taille M2, 15,675 × 15,675 mm² à 9,5 A).

**Tableau 1**

| Maillage | Cellule (Type) | Taille de maille (mm) | Diamètre (mm) | Nœuds inter-cellules | Ombrage (%) | Courant/Section (A/mm²) |
|---|---|---|---|---|---|---|
| Kagomé | 0,52 A III-V 4×8 cm² | 20 | 0,1 | 5 | 2 | 13,2 |
| Kagomé | 9,5 A Si taille M2 | 19,5 | 0,25 | 13 | 3,8 | 14,9 |
| Triangulaire | 0,52 A III-V 4 × 8 cm² | 20 | 0,2 | 3 | 3,3 | 5,5 |
| Triangulaire | 9,5 A Si taille M2 | 39 | 0,55 | 3 | 4,7 | 13,3 |

Il faut noter que ces paramètres ont été calculés avec un positionnement le plus défavorable comprenant un faible nombre de nœuds 28 dans la zone inter-cellules.

Afin de diminuer l'ombrage sur les cellules 3 et d'économiser de la matière, il est possible de ne recouvrir que partiellement la surface S de chaque cellule 3, comme visible sur la figure 8. Il est également possible d'utiliser plusieurs éléments d'interconnexion 20, par exemple sous forme de bandes, comme visible sur les figures 9 et 10. Ces bandes peuvent s'étendre sur toute la longueur de la surface S, comme visible sur la figure 9, ou bien encore s'étendre partiellement sur la longueur de la surface S, comme visible sur la figure 10. En variante, il est aussi possible d'utiliser une ou plusieurs bandes dans une zone centrale uniquement, et non en périphérie de la surface S de chaque cellule 3. De plus, il faut noter que l'interconnexion entre deux cellules 3 consécutives peut être réalisée selon le sens de la longueur ou de la largeur des cellules 3.

Par ailleurs, chaque élément d'interconnexion 20 peut comporter un matériau conducteur électrique sous la forme d'un ou plusieurs métaux, tels que le cuivre ou l'argent, et/ou d'alliages métalliques, par exemple à base de cuivre et d'argent. Ces métaux et/ou alliages peuvent être recouverts d'un revêtement formé par un alliage métallique conducteur présentant une gamme de température de fusion peu élevée, compatible avec celle de la lamination. Avantageusement, il est alors possible de souder et de laminer en une seule étape. Il faut noter que la notion de section de l'élément d'interconnexion 20 correspond à la section du matériau conducteur électrique, celle du revêtement éventuel étant négligeable.

Ce revêtement à bas point de fusion peut être formé par un ou plusieurs alliages métalliques de type SnBiAg (alliages à base d'étain-bismuth-argent), tels que Sn₄₂Bi₅₈, Sn₆₄Bi₃₅Ag₁, Sn_{64.7}Bi₃₅Ag_{0.3}, Sn42Bis7.6Ago.4, Sn₄₂Bi₅₇Ag₁, Sn_{96.5}Ag_{3.0}Cu_{0.5} ou encore Sn_{96.5}Ag_{3.5}.

Selon une alternative, il est aussi possible que le matériau conducteur électrique soit recouvert par un revêtement d'alliage de Fer et de Nickel, notamment de type Invar^{®} (64 % de Fe, 36 % de Ni) ou d'alliage de Fer, Nickel et Cobalt, notamment de type Kovar^{®} (53,5 % de Fe, 29 % de Ni, 17% de Co, 0,3% de Mn, 0,2% de Si, 0,02% de C).

En outre, la fabrication d'un élément d'interconnexion 20 conforme à l'invention peut se faire par différentes approches, et notamment : retrait de matière, impression 3D ou tissage. Ce type d'élément d'interconnexion 20 permet de simplifier le procédé de fabrication du module photovoltaïque 5 car le ou les éléments d'interconnexion 20 sont disposés en même temps que les cellules 3 et ne nécessitent pas d'étape de soudure. La connexion électrique est obtenue lors de l'étape de lamination.

Bien entendu, l'invention n'est pas limitée aux exemples de réalisation qui viennent d'être décrits. Diverses modifications peuvent y être apportées par l'homme du métier.

En particulier, tout type de cellule photovoltaïque 3 peut être utilisé dans le cadre de l'invention, dont par exemple des cellules à contact face arrière, ou des configurations de type « flip/flop » (« retourné »), c'est-à-dire avec une interconnexion de cellules consécutives bifaciales (face avant à face avant, puis face arrière à face arrière), ou de type « shingle » (« tuile »), c'est-à-dire avec une interconnexion de cellules par recouvrement partiel), ou de type « tilling/paving » (« carrelage/pavage »), c'est-à-dire avec une interconnexion de cellules avec espacement réduit), entre autres.

## Revendications

1. Assemblage d'au moins deux cellules photovoltaïques (3) destiné à former un module photovoltaïque (5), lesdites au moins deux cellules photovoltaïques (3) étant interconnectées électriquement entre elles par le biais d'au moins un élément d'interconnexion électrique (20) comportant au moins un matériau conducteur électrique, **caractérisé en ce que** :
- l'élément d'interconnexion (20) se présente sous la forme d'un maillage comprenant une géométrie fractale formée par la répétition d'un motif unitaire (25) par translation pour obtenir une pluralité de motifs unitaires (25) de même taille et/ou par changement de taille du motif unitaire (25) pour obtenir une similarité du motif unitaire (25) à différentes échelles,
- l'élément d'interconnexion (20) présente un rapport entre le courant électrique conduit entre deux cellules photovoltaïques consécutives (3) et la section totale dudit au moins un matériau conducteur électrique entre deux cellules photovoltaïques consécutives (3) compris entre 0,1 et 20 A/mm²,
- chaque cellule photovoltaïque (3) comporte une surface (S) sur laquelle ledit au moins un élément d'interconnexion (20) est disposé au moins en partie, la fraction de la surface (S) recouverte par ledit au moins un élément d'interconnexion (20) étant comprise entre 10 et 100%.

2. Assemblage selon la revendication 1, **caractérisé en ce que** l'élément d'interconnexion (20) présente un rapport entre le courant électrique conduit entre deux cellules photovoltaïques consécutives (3) et la section totale dudit au moins un matériau conducteur électrique entre deux cellules photovoltaïques consécutives (3) compris entre 0,5 et 15 A/mm².

3. Assemblage selon la revendication 1 ou 2, **caractérisé en ce que** l'élément d'interconnexion (20) présente une géométrie planaire.

4. Assemblage selon l'une des revendications précédentes, **caractérisé en ce que** la taille de maille (D) de l'élément d'interconnexion (20), définie comme la longueur du côté (D) du plus petit carré fictif dans lequel est inscrit le motif unitaire (25), est comprise entre 1 et 80 mm, notamment entre 10 et 50 mm.

5. Assemblage selon l'une quelconque des revendications précédentes, **caractérisé en ce que** la géométrie fractale par changement de taille du motif unitaire (25) est faite à un ordre supérieur ou égal à 1, à savoir qu'elle comporte une similarité du motif unitaire (25) à au moins deux échelles différentes.

6. Assemblage selon l'une quelconque des revendications précédentes, **caractérisé en ce que** l'élément d'interconnexion (20) présente une capacité de déformation supérieure ou égale à 20 %, notamment supérieure ou égale à 40 %.

7. Assemblage selon l'une quelconque des revendications précédentes, **caractérisé en ce que** l'élément d'interconnexion (20) se présente sous la forme d'un maillage de type triangulaire, de type pavage trihexagonal, encore appelé kagomé, ou de type nid d'abeilles.

8. Assemblage selon l'une quelconque des revendications précédentes, **caractérisé en ce que** chaque cellule photovoltaïque (3) comporte une surface (S) sur laquelle ledit au moins un élément d'interconnexion (20) est disposé au moins en partie, et **en ce que** l'ombrage dudit au moins un élément d'interconnexion (20) sur une surface (S) d'une cellule photovoltaïque (3) destinée à recevoir un flux lumineux, à savoir le recouvrement de cette surface (S) par ledit au moins un élément d'interconnexion (20) empêchant le passage du flux lumineux, est compris entre 0,2 % et 5 % de la surface (S) de la cellule photovoltaïque (3), notamment compris entre 0,2 % et 3 % de la surface (S) de la cellule photovoltaïque (3).

9. Assemblage selon l'une quelconque des revendications précédentes, **caractérisé en ce que** chaque cellule photovoltaïque (3) comporte une surface (S) sur laquelle ledit au moins un élément d'interconnexion (20) est disposé en totalité.

10. Assemblage selon l'une quelconque des revendications 1 à 8, **caractérisé en ce que** chaque cellule photovoltaïque (3) comporte une surface (S) sur laquelle ledit au moins un élément d'interconnexion (20) est disposé en partie.

11. Assemblage selon l'une quelconque des revendications précédentes, **caractérisé en ce que** la fraction de la surface (S) recouverte par ledit au moins un élément d'interconnexion (20) est comprise entre 50 et 100 %, notamment entre 80 et 100 %.

12. Assemblage selon l'une quelconque des revendications précédentes, **caractérisé en ce que**, dans la zone inter-cellules (Z) correspondant à la partie dudit au moins un élément d'interconnexion (20) située entre deux cellules photovoltaïques (3) consécutives, sans recouvrement d'une surface (S) de cellule photovoltaïque (3), le nombre de nœuds (28), correspondant au lieu de réunion d'au moins deux motifs unitaires (25), est compris entre 2 et 50, notamment entre 5 et 15.

13. Module photovoltaïque (5), **caractérisé en ce qu'**il comporte un assemblage selon l'une quelconque des revendications précédentes.

14. Procédé d'interconnexion électrique d'au moins deux cellules photovoltaïques (3), **caractérisé en ce qu'**il comporte l'étape consistant à interconnecter au moins deux cellules photovoltaïques (3) d'un assemblage selon l'une quelconque des revendications 1 à 12 au moyen dudit au moins un élément d'interconnexion (20).
